# EUROPEAN PATENT APPLICATION

(11) **EP 2 362 430 A1**
(43) Date of publication of application: **31.08.2011**
(21) Application number: 10425041.0
(22) Date of filing: 18.02.2010
(51) Int. Cl.: H01L 31/048, H01L 31/05

(54) **A photovoltaic module**

(71) Applicant: SAVIO S.p.A., 10050 Chiusa San Michele (Torino) (IT)
(72) Inventor: Balbo di Vinadio, Aimone, 10050 Chiusa San Michele (Torino) (IT); Palazzetti, Mario, 10050 Chiusa San Michele (Torino) (IT)
(74) Representative: Marchitelli, Mauro

(57) **Abstract**

A photovoltaic module (10) comprising at least one array (12) of photovoltaic cells (14), electrically connected in series to one another, wherein each cell has two opposite faces with different polarities, two longitudinal sides (16) parallel to one another, and two transverse sides (18) parallel to one another, wherein the electrical connection in series between adjacent cells (14) is obtained by overlapping of respective edges (20) adjacent to said transverse sides (18).

## Description

### Field of the invention

The present invention relates to a photovoltaic module comprising at least one array of photovoltaic cells aligned and electrically connected in series to one another.

The present invention can be applied both to solar panels without concentrators and to receivers for concentration photovoltaic apparatuses.

### Description of the relevant art

The photovoltaic cells used in the production of a photovoltaic module are constituted by thin films of semiconductor material. In a photovoltaic module, the cells are arranged in one or more arrays, with the cells of each array electrically connected in series to one another. In each array the cells are arranged with respective longitudinal sides aligned to one another and with parallel transverse sides that are set at a distance from one another.

The electrical connection in series between the adjacent cells is obtained by means of metal ribbons, each of which is welded to the top conductors of a first cell and to the bottom surface of a second cell adjacent to the first.

The electrical connection in series between the adjacent cells using ribbons presents a series of drawbacks. In the first place, welding of the ribbons to the cells can be affected by defects that involve wastes. In addition, connection by means of ribbons does not enable arrangement of the cells with the respective transverse sides in contact with one another. The ribbons have moreover an encumbrance that masks the corresponding surface portions of the cell, thus reducing the useful surface of the cells. The encumbrance of the ribbons may become important in concentration photovoltaic systems, in which the currents produced by the cells are high and require ribbons with large cross sections.

### Object and summary of the invention

The object of the present invention is to provide a photovoltaic module that will enable the aforesaid drawbacks to be overcome.

According to the present invention, said object is achieved by a photovoltaic module having the characteristics that form the subject of Claim 1.

The claims form an integral part of the teaching provided herein in relation to the invention.

### Brief description of the drawings

The present invention will now be described in detail with reference to the attached drawings, which are provided purely by way of non-limiting example and in which:
- Figure 1 is a top plan view of a photovoltaic module according to the present invention;
- Figure 2 is a cross section according to the line II-II;
- Figure 3 is a top plan view at a larger scale of the part indicated by the arrow III in Figure 1; and
- Figure 4 is an enlarged detail of the part indicated by the arrow IV in Figure 2.

### Description of embodiments of the invention

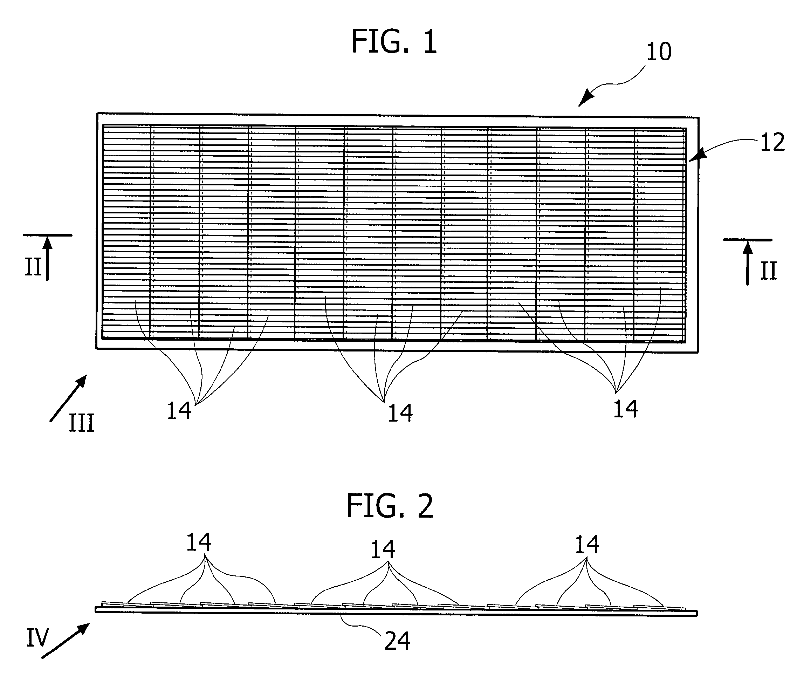

In Figure 1 designated by 10 is a photovoltaic module according to the present invention. The photovoltaic module 10 illustrated in the drawings is designed to be used in a concentration photovoltaic apparatus. However, it is understood that the present invention may be adopted also in photovoltaic panels designed to be used without concentration devices.

The photovoltaic module 10 comprises an array 12 formed by a plurality of photovoltaic cells 14 aligned to one another. In the example illustrated, each photovoltaic cell 12 has a rectangular shape, for example, with dimensions of 25 x 100 cm. The shape and dimensions of the photovoltaic cells 14 may vary according to the applications. Typically, in the case of photovoltaic panels not associated to concentration devices the cells have a square shape, possibly with rounded edges.

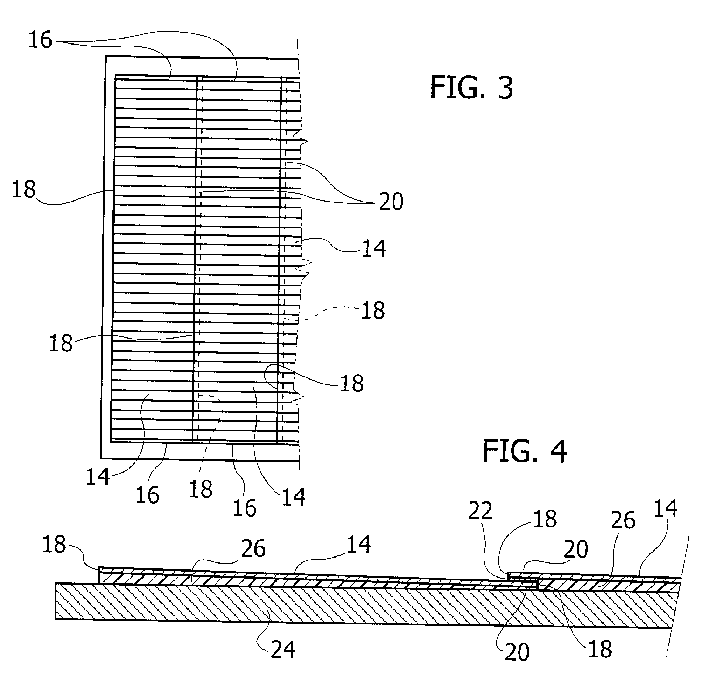

With reference to Figure 3, each photovoltaic cell 14 has two longitudinal sides 16 parallel to one another and two transverse sides 18, which are also parallel to one another. In the example illustrated, the longitudinal sides 16 are the minor sides of the cells 14. The photovoltaic cells 14 are arranged to form the array 12 with the respective longitudinal sides 16 aligned to one another.

The photovoltaic cells 14 of the array 12 are electrically connected in series to one another. According to the present invention, the electrical connection in series between adjacent cells 14 is obtained by overlapping respective edges 20 adjacent to the transverse sides 18.

As illustrated in Figure 4, the electrical connection between the overlapping edges 20 of two adjacent photovoltaic cells 14 can be, for example, obtained with a layer of conductive glue 22. Alternatively, a connection could be obtained by means of brazing or by means of any one other system designed to establish an electrical connection and a mechanical connection between the overlapping edges 20.

The photovoltaic cells 14 have opposite polarities on the two main faces. Consequently, overlapping between the edges 20 sets in direct electrical contact areas with different polarities of the adjacent cells 14.

In the embodiment illustrated in the figures, the photovoltaic cells 14 are carried by a supporting plate 24, which faces the bottom faces of the cells 14. The supporting plate 14 is preferably made of metal material with good thermal transmission, such as, for example, aluminium or its alloys. Set between the bottom faces of the photovoltaic cells 14 and the supporting plate 24 is a layer of electrically insulating material 26. Preferably, the layer 26 is thermally conductive so that the heat due to the solar concentration on the cells 14 will be transferred to the supporting plate 24. On the bottom face of the plate 24 a finned dissipator element (not illustrated) can be applied, or else the supporting plate 24 can be associated to a liquid-cooling system. The material constituting the insulating layer 26 can, for example, be a polymeric paste with fillers of insulating material with good thermal conductivity. In the polymeric paste fibres can be dispersed, for example glass fibres, having the purpose of preventing a contact between the edges of the photovoltaic cells 14 with the metal supporting plate 24.

The layer of insulating material 26 could also be constituted by a preformed strip of electrically insulating and thermally conductive material, having a top surface shaped so as to mate with the bottom surface of the cells 24. As a further alternative, the top face of the supporting plate 24 could be machined so as to present a surface complementary to the bottom surfaces of the photovoltaic cells 14, and the insulating layer 26 could be constituted by a electrically insulating and thermally conductive paint applied to the top surface of the plate 24.

The metal supporting plate 24 is useful in particular in the application of the photovoltaic module 10 to concentration apparatuses. In the case where the photovoltaic module 10 is not designed for use in concentration apparatuses, the supporting plate 24 may be omitted. In this case, on the bottom surface of the photovoltaic cells 24 a polymeric sheet, for example made of Teflon, may be applied. In the application to photovoltaic modules without concentration, on the top surface of the photovoltaic cells 14 a glass plate is preferably applied. Between the glass plate and the top surface of the photovoltaic cells 14 there can be set a layer of transparent plastic material, such as, for example, EVA. Assembly of the photovoltaic cells with the glass plate and the EVA layer can be carried out with lamination techniques, in a way altogether similar to the techniques of production of photovoltaic panels of a conventional type.

In photovoltaic modules designed for use in panels without concentration, a number of arrays of photovoltaic cells 12 are generally provided, in which the cells of each array are electrically connected in series as described previously and in which the various arrays can be electrically connected to one another in series or in parallel with conventional techniques.

## Claims

1. A photovoltaic module (10) comprising at least one array (12) of photovoltaic cells (14) electrically connected in series to one another, wherein each cell (14) has two opposite faces with different polarities, two longitudinal sides (16) parallel to one another, and two transverse sides (18) parallel to one another, said photovoltaic module being **characterized in that** the electrical connection in series between adjacent cells (14) of said array (12) is obtained by overlapping of respective edges (20) adjacent to said transverse sides (18).

2. The photovoltaic module according to Claim 1, **characterized in that** said overlapped edges (20) are electrically and mechanically connected to one another with a layer of conductive glue (22).

3. The photovoltaic module according to Claim 1, **characterized in that** said overlapped edges (20) are electrically and mechanically connected to one another by brazing.

4. The photovoltaic module according to Claim 1, **characterized in that** said photovoltaic cells (12) are carried by a supporting plate (24) with the interposition of a layer (26) of electrically insulating material.

5. The photovoltaic module according to Claim 4, **characterized in that** said supporting plate (24) is made of metal material and **in that** said layer (26) of electrically insulating material is thermally conductive.

6. The photovoltaic module according to Claim 5, **characterized in that** said layer of electrically insulating material (26) is formed by a matrix of plastic material with fillers of electrically insulating and thermally conductive material.

7. The photovoltaic module according to Claim 5, **characterized in that** said layer (26) of electrically insulating material is formed by a strip with a surface of a shape complementary to the bottom surface of the array (12) of photovoltaic cells (14) with edges (20) overlapping one another.

8. The photovoltaic module according to Claim 5, **characterized in that** said metal supporting plate (24) has a top surface with a shape complementary to the shape of the array (12) of photovoltaic cells (14) with edges (20) overlapping one another.

9. The photovoltaic module according to Claim 8, **characterized in that** said layer of electrically insulating material (26) is a paint.

10. The photovoltaic module according to Claim 1, **characterized in that** said photovoltaic cells (14) have a rectangular shape and are set with the respective minor sides (16) aligned to one another in a longitudinal direction and with said overlapping edges (20) adjacent to the respective major sides (18).

11. The photovoltaic module according to Claim 1, **characterized in that** it comprises a plurality of arrays of photovoltaic cells set alongside one another.

12. The photovoltaic module according to Claim 1, **characterized in that** said photovoltaic cells (14) are coupled to a glass plate via a layer of transparent plastic material.
